# NEUE EUROPÄISCHE PATENTSCHRIFT

(11) **EP 2 399 435 B2**
(45) Veröffentlichungstag und Bekanntmachung des Hinweises auf die Entscheidung über den Einspruch: **01.12.2021**
(45) Hinweis auf die Patenterteilung: 01.04.2015
(21) Anmeldenummer: 10703832.5
(22) Anmeldetag: 03.02.2010
(51) Int. Cl.: H05K 7/14, H01R 9/26, H01R 9/24, H01R 24/64, H01R 13/648

(54) **ANREIHBARES ELEKTRONIKGEHÄUSE**
MODULAR ELECTRONICS HOUSING
BOÎTIER ÉLECTRONIQUE ALIGNABLE

(30) Priorität: 23.02.2009 DE 202009002498 U
(43) Veröffentlichungstag der Anmeldung: 28.12.2011
(73) Patentinhaber: Weidmüller Interface GmbH & Co. KG, 32758 Detmold (DE)
(72) Erfinder: VAN GIESEN, Bernd, 32756 Detmold (DE); HANKE, Dirk, 32657 Lemgo (DE); STUCKMANN, Peter, 32791 Lage (DE); LANGE, Stephan, 32657 Lemgo (DE); NIGGEMANN, Matthias, 32657 Lemgo (DE); WAGNER, Georg, 33818 Leopoldshöhe (DE); BROKMANN, Jens, 32760 Detmold (DE); WIBBEKE, Katrin, 33098 Paderborn (DE); SCHARLIBBE, Heinz, 32457 Porta Westfalica (DE); WEDLER, Andreas, 32756 Detmold (DE)
(74) Vertreter: Specht, Peter
(86) Internationale Anmeldenummer: PCT/EP2010/051304
(87) Internationale Veröffentlichungsnummer: WO 2010/094563

(56) Entgegenhaltungen:
- EP-A2- 1 326 304
- EP-A2- 2 091 105
- DE-A1-102006 036 964

## Beschreibung

Die Erfindung betrifft ein anreihbares Elektronikgehäuse nach dem Oberbegriff des Anspruchs 1.

Derartige Elektronikgehäuse sind an sich bekannt, bedürfen aber hinsichtlich ihrer elektromagnetische Durchschlagssicherheit bzw. ihres ESD-Schutzes (ESD: Electro Static Discharge) einer weiteren konstruktiven Optimierung.

Aus der EP 1 326 304 A2 ist ein Elektronikgehäuse nach dem Oberbegriff des Anspruchs 1 bekannt.

Die Erfindung hat die Aufgabe, auf einfache Weise die Möglichkeit zu schaffen, ein Kunststoffgehäuse mit darin aufgenommener Elektronik mit einer Leiterplatte besonders ESD-sicher auszulegen.

Die Erfindung löst diese Aufgabe durch den Gegenstand des Anspruchs 1.

Aus der nachveröffentlichten EP 2 091 105 sind die Merkmale a. -c. des Anspruchs 1 bekannt.

Vorzugsweise sind an der wenigstens einen oder an der Leiterplatte einer oder mehrere Steckverbinder angeordnet und das Seitenteil oder die Seitenteile sind an den Steckverbindern verrastbar. Derart wird die Montage deutlich vereinfacht, da die Steckverbinder und die Seitenteile an der Leiterplatte LP vormontiert sind und dieses empfindliche Bauteil bei der Montage im Gehäusesockel gut geschützt ist. Derart bildet die wenigstens eine Leiterplatte mit den Steckverbinder und den Seitenteilen eine vormontierbare Einheit, die in den Gehäusesockel einsetzbar ist.

Besonders bevorzugt sind die Steckverbinder als Stiftleisten oder als Buchsenleisten ausgebildet. Andere Ausgestaltungen, so beispielsweise als RJ45-Stecker - oderbuchse - sind denkbar.

Vorzugsweise bildet die Leiterplatte mit den Steckverbindern und den Seitenteilen eine vormontierte Einheit, die in den Gehäusesockel einsetzbar ist. Hierdurch wird die Fertigung einfach und besonders übersichtlich.

Vorteilhafte Ausgestaltungen der Erfindung sind den Unteransprüchen zu entnehmen.

Nachfolgend werden Ausführungsbeispiele der Erfindung unter Bezug auf die Figuren näher beschrieben. Es zeigt:
- Figur 1: eine perspektivische Sprengansicht von Bauelementen eines Elektronikgehäuses;
- Figur 2: Bauelemente eines Elektronikgehäuses in einer Seitenansicht in Anreihrichtung;

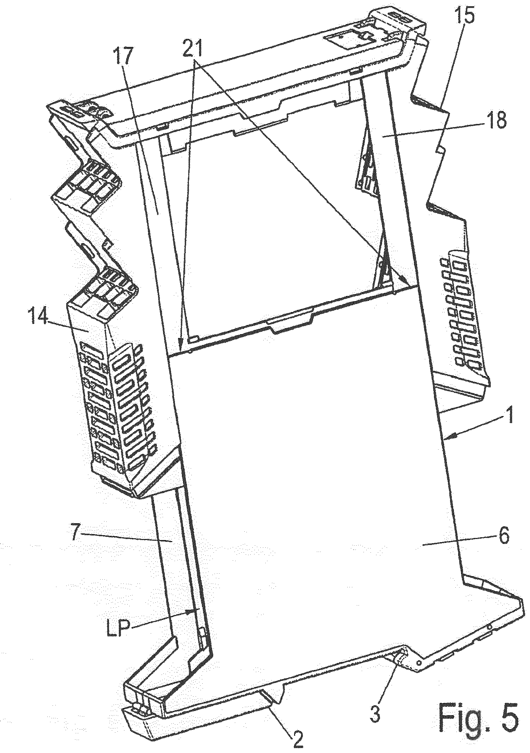

- Figur 3-5: perspektivische Ansichten des Elektronikgehäuses aus Fig.1 in verschiedenen Zusammenbaustadien einzelner Baugruppen des Elektronikgehäuses;

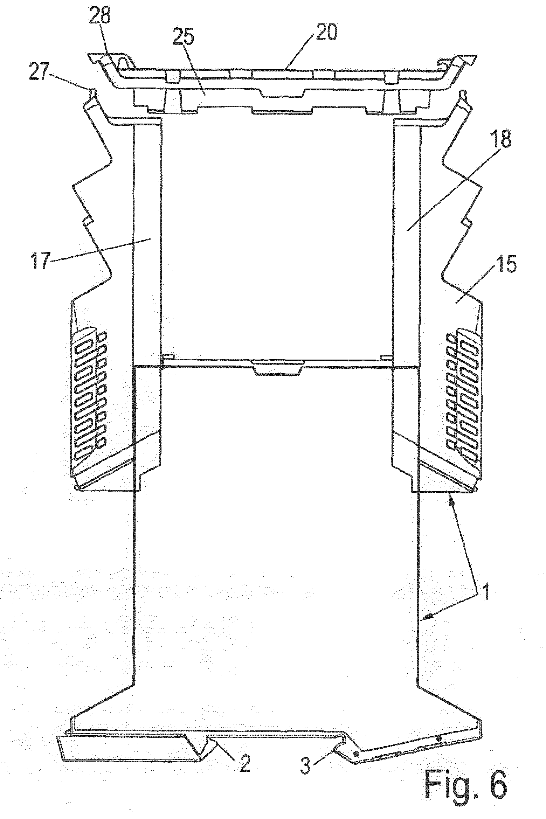

- Figur 6: eine Seitenansicht des Elektronikgehäuses aus Fig.1 in einem Zusammenbaustadium.

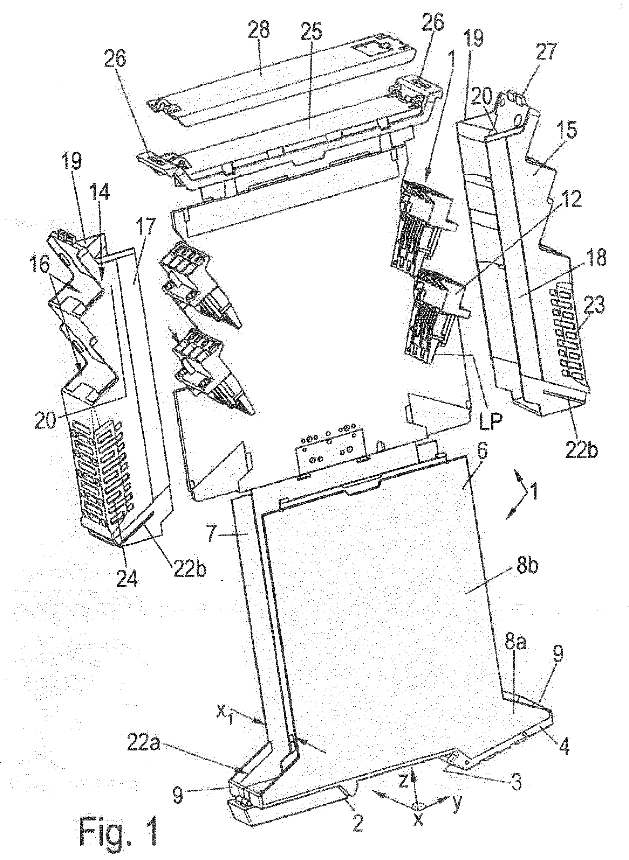

Figur 1 zeigt eine perspektivische Ansicht eines mehrteiligen, anreihbaren Elektronikgehäuses 1, welches mit einem Rastfuß mit Rastmitteln 2, 3 zum Aufrasten auf eine hier nicht dargestellte, vorzugsweise U-förmige Tragschiene versehen ist. Die Aufrastbarkeit auf eine Tragschiene ist die bevorzugte - aber nicht zwingende-Auslegung. Es wäre auch denkbar, das Grundgehäuse 1 zum Auflegen auf eine andere Art von Montagebasis auszulegen, wozu die Rastfüße entsprechend zu modifizieren wären.

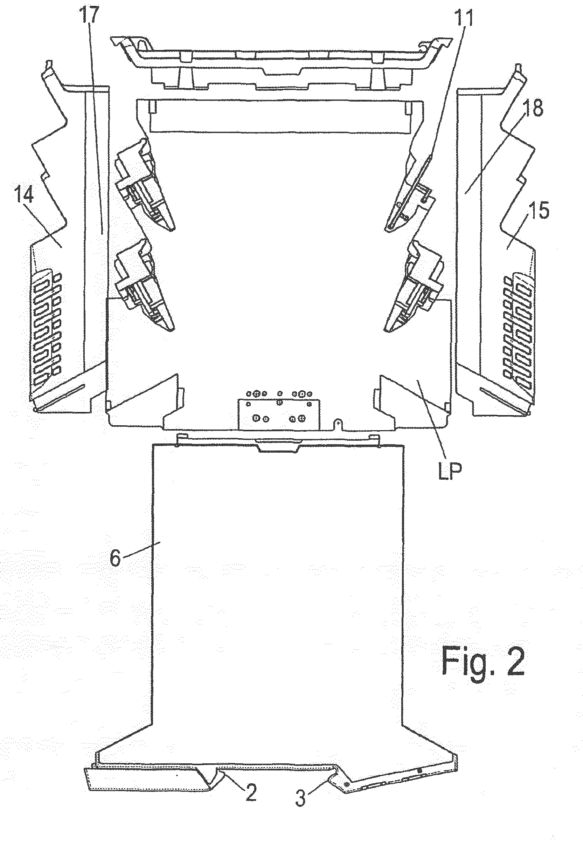

Die Elektronikgehäuse 1 sind senkrecht zur Tragschienenrichtung, d.h. senkrecht zur Ebene der Figur 2 aneinander anreihbar.

Das Elektronikgehäuse 1 weist einen vorzugsweise einstückig als Spritzgussteil aus Kunststoff ausgebildeten Gehäusesockel 4 auf, der den Rastfuß mit den Rastmitteln 2, 3 aufweist, wobei das eine der Rastmittel 3 eine Rastkante und das andere Rastmittel eine Art Schieber bzw. Betätigungsschieber 2 sein kann.

Der Gehäusesockel 4 weist vorzugsweise ferner zur Tragschiene hin einen Bodenabschnitt 5 auf (hier nur im Bereich der Rastkante 3 zu erkennen), der zur Realisierung einer ESD-sicheren Variante ganz oder weitestgehend geschlossen ausgebildet oder mit Öffnungen z.B. zur Realisierung von Lüftschlitzen oder Lüftkanälen bei einer weniger ESD-sicheren Variante versehen sein kann.

Der Bodenbereich 5 erstreckt sich vorzugsweise beidseits der Tragschiene. Im Bereich des Rastfußes kann ein Mittel (hier nicht dargestellt) zur Kontaktierung einer Busleiste in der Tragschiene vorgesehen sein.

An den Bodenbereich 5 schließen sich senkrecht nach oben von der Tragschiene weg zwei Seitenwände 6, 7 an, die vorzugsweise parallel zueinander ausgerichtet sind und die im Abstand X₁ - dem Rastermaß des Elektronikgehäuses liegen. Diese Seitenwände werden nachfolgend als Hauptseitenwände 6, 7 (siehe Fig. 1) bezeichnet. Sie geben die Breite X₁ des Elektronikgehäuses 1 in Anreihrichtung X vor.

Die Hauptseitenwände 6, 7 erstrecken sich senkrecht zur Anreihrichtung X oberhalb der Tragschiene. Sie weisen von der Tragschiene aus betrachtet in dieser Richtung "Z" zunächst einen in Y-Richtung zunächst breiteren Basisbereich 8a auf, der sich beidseits der Tragschiene erstreckt und in Z-Richtung oberhalb dieses Basisbereichs 8 einen schmaleren Bereich 8b, so dass die Hauptseitenwände 6, 7 - relativ zur Tragschiene - im Wesentlichen die Kontur eines umgedrehten T aufweisen.

Es ist möglich, dass der Gehäusesockel zumindest im Bereich des Basisbereiches 8a auch die Hauptseitenwände 6, 7 im Basisbereich 8a verbindende - relativ kurze - Seitenwandabschnitte 9 aufweist.

Im Grundgehäuse 1 wird zwischen den Seitenwänden 6, 7 ein Aufnahmeraum für wenigstens eine oder aber mehrere Leiterplatte(n) LP geschaffen, wie sie in Figur 1 im oberen Teil dargestellt ist.

Diese Leiterplatte LP weist vorzugsweise - jedenfalls abschnittsweise - nahezu sägezahnartige Seitenkonturen auf, wobei gestufte Abschnitte 10 (Fig. 1, 2), welche am Leiterplattenrand ausgebildet sind, dazu genutzt werden, auf dem Rand der Leiterplatte LP wenigstens eine oder mehrere Stiftleiste(n) 11 (oder alternativ Buchsenleisten) anzuordnen, die mit der Leiterplatte über Kontaktbereiche (hier nicht im einzelnen zu erkennen) leitend, z. B. mittels einer Löttechnik, verbunden ist.

Auf die Stiftleiste können Gehäuse 12 gesetzt sein, die Anschlusskammern 13 aufweisen, die durch Zwischenwände voneinander getrennt sind und jeweils dazu ausgelegt sind, einen der Anschlussstifte der Stiftleiste 11 aufzunehmen (siehe Fig. 1 und 2).

Die Stiftleisten 11 sitzen jeweils auf den gestuften Abschnitten 10 vorzugsweise derart, dass sie sich im wesentlichen senkrecht beidseits des Leiterplattenrandes erstrecken, wobei sie jeweils auf unteren Schenkeln der gestuften Abschnitte 10 aufliegen, derart, dass in sie im wesentlichen aus einer Richtung relativ zur Tragschiene "von oben nach unten" die korrespondierenden Buchsenleisten (hier nicht dargestellt) einsteckbar sind.

Der Gehäusesockel 4 weist im Bereich oberhalb der Basis zwischen den Hauptseitenwänden 6, 7 keine mit ihm einstückig verbundenen Seitenteile auf, welche das Elektronikgehäuse 1 rundum abschließen.

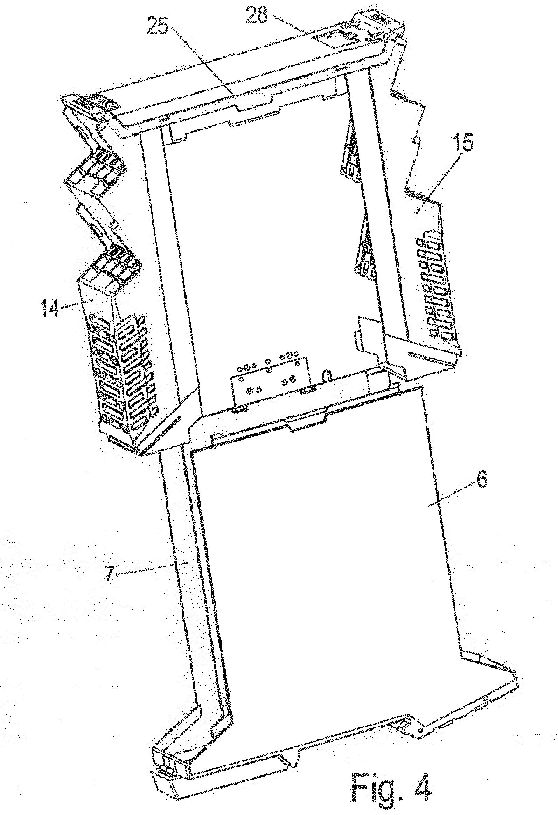

Bei dem Konzept der Figuren 1 bis 4 ist vielmehr vorgesehen, am Gehäusesockel 4 festlegbare Seitenteile 14, 15 zu realisieren, die an das Grundgehäuse 1 ansetzbar und dort vorzugsweise rastend festlegbar sind. Sie verbinden die Hauptseitenwände 6, 7 miteinander und sind senkrecht zu diesen ausgerichtet.

In der Draufsicht weisen diese Seitenteile 14, 15 im Wesentlichen eine U-förmige Kontur auf.

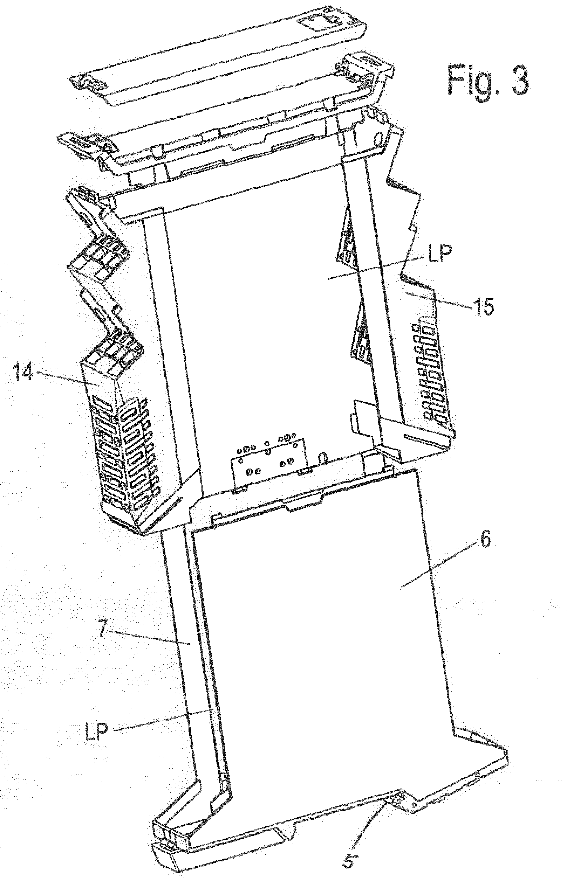

Die U-förmigen Seitenteile 14, 15 weisen in der Seitenansicht der Figur 3 eine ebenfalls abschnittsweise gestufte Kontur auf, die mit Aussparungen 16 versehen ist, die derart ausgebildet und angeordnet sind, dass in ihnen im zusammengebauten Zustand die Stiftleisten 11 zu liegen kommen, wobei es möglich ist, die Stiftleisten 11 mit den Buchsenleisten durch die Aussparung 16 hindurch zu kontaktieren.

Die Seitenteile 14, 15 weisen - insbesondere im Bereich ihrer Längsschenkel an deren Rändern in Z-Richtung - Randabschnitte 17, 18 auf, in denen die Wandstärke der Seitenteile an ihren voneinander abgewandten Außenflächen etwas geringer ist als in ihrem übrigen Bereich.

Dabei ist der Abstand der Längsschenkel 19, 20 der Seitenteile 14, 15 derart bemessen, dass ihr äußerer Abstand dem Abstand X1 der Wände 6, 7 entspricht. Die Randabschnitte 17, 18 sind dagegen derart ausgelegt, dass sie in Anreihrichtung von innen die Wände 6, 7 hintergreifen, derart, dass im zusammengesetzten Zustand ein Überlappungsbereich 21 zwischen den Randabschnitten 17, 18 und deren Wänden 6, 7 gebildet wird.

Dieser Überlappungsbereich 21 ist erfindungsgemäß jeweils mehr als 5mm breit. Vorzugsweise ist er zur weiteren Optimierung 6 bis 9 mm breit, insbesondere ist er 8mm breit.

Auch in dem Bereich, in welchem die Seitenteile 14, 15 in den Sockelbereich eingreifen ist ein entsprechend großer Überlappungsbereich ausgebildet. Hier kann es zusätzlich vorgesehen sein, dass sich Rippen 22a, 22b an den Seitenteilen und an dem Sockelbereich wechselseitig hintergreifen, was die Seitenteile 14, 15 ergänzend an dem Sockelteil sichert (Fig. 1).

Derart ist es möglich, das Elektronikgehäuse in diesem unteren zur Tragschiene gerichteten Bereich elektrotechnisch besonders durchschlagssicher auszugestalten, wobei in der bevorzugten durchschlagsicheren Ausgestaltung dann keine Lüftungsöffnungen 23, 24 in den Seitenteilen ausgestaltet werden (diese Variante ist hier nicht dargestellt). Hierdurch wird in einfacher Weise ein ESD-sicheres Elektronikgehäuse realistisiert.

Vorzugsweise bestehen sämtliche Teile des Elektronikgehäuses, also insbesondere das Grundgehäuse und die Seitenteile 14, 15 aus isolierendem Kunststoff.

Denkbar ist es aber auch, die Seitenteile 14, 15 aus Metall zu fertigen und/oder die Komponenten des Elektronikgehäuses aus unterschiedlichen Materialien wie z.B. Kunststoff oder Metall zu fertigen.

In X-Richtung beträgt die Erstreckung des Elektronikgehäuses 1 der Fig. 1 z.B. 12,5 mm.

Nach oben abgeschlossen wird das Elektronikgehäuse 1 von einem Deckelteil 25, das vorzugsweise an den Seitenteilen 14, 15 und an den Hauptseitenwänden 5, 6 rastend oder klemmend festlegbar ist. Nach Fig.1 erfolgt diese Verrastung vorzugsweise nach Art einer Klammer mit Öffnungen 26, welche von Rastvorsprüngen 27 an den Seitenwänden durchsetzt werden, so dass das Deckelteil 25 ein Auseinanderziehen der Seitenteile 14, 15 senkrecht zur Tragschiene (in Y-Richtung) verhindert. Das Deckelteil 25 kann auch weitere Anschlüsse aufnehmen und/oder für Markierzwecke genutzt werden und hierzu ggf. mit einer vorzugsweise transparenten Abdeckung 28 versehen werden.

Es ist denkbar, die Elektronikgehäuse 1 derart auszugestalten, dass sie jeweils zwei oder mehr Leiterplatten LP aufnehmen (hier nicht dargestellt). Zudem können beispielsweise durch Verändern der Seitenteile bzw. durch verschiedene Seitenteile 14, 15 Elektronikgehäuse mit mehr oder weniger großer Lüftungsfunktion oder Kühlfunktion realisiert werden.

Während die Seitenteile 14, 15 hier derart ausgelegt sind, dass an ihnen Stiftleisten kontaktierbar sind, können die Aussparungen 16 auch derart gestaltet werden, dass andere Anschlüsse durch sie erreichbar sind, so beispielsweise Stecker im RJ45-Format, lichtleitende Stecker oder aber Stecker oder Buchsen anderer Art.

Durch die Sägezahnform ist es möglich, in Richtung senkrecht zur Tragschiene relativ hoch zu bauen, was vorteilhaft ist, da in dieser Richtung der Bauraum meist eher weniger beschränkt ist.

**Bezugszeichen**

| | |
|---|---|
| Grundgehäuse | 1 |
| Rastmittel | 2,3 |
| Gehäusesockel | 4 |
| Bodenabschnitt | 5 |
| Seitenwand | 6,7 |
| Basisbereich | 8 |
| Seltenwandabschnitt | 9 |
| Leiterplatte | 9 |
| Abschnitt | 10 |
| Stiftleiste | 11 |
| Gehäuse | 12 |
| Anschlusskammer | 13 |
| Seitenteil | 14, 15 |
| Aussparungen | 16 |
| Randabschnitte | 17,18 |
| Längsschenkel | 19,20 |
| Überlappungsbereich | 21 |
| Rippen 2 | 22a, 22b |
| Öffnungen | 23,24 |
| Deckelteil | 25 |
| Öffnungen | 26 |
| Rastvorsprünge | 27 |
| Abdeckung | 28 |
| Richtungen | X, Z |
| Baubreite | X1 |
| Leiterplatte | LP |

## Patentansprüche

1. Mehrteiliges anreihbares Elektronikgehäuse (1) zur Aufnahme wenigstens einer Leiterplatte (LP) oder mehrerer Leiterplatten (LP).
a. mit einem Rastfuß mit Rastmitteln (2, 3) zum Aufrasten auf eine als Tragschiene ausgebildete Montagebasis,
b. mit einem vorzugsweise einstückig ausgebildeten Gehäusesockel (4), der den Rastfuß aufweist sowie einen Bodenabschnitt (5) und zwei zueinander parallele Hauptseitenwände (6, 7) aufweist, die das Elektronikgehäuse jeweils in Anreihrichtung begrenzen,
c. mehrere separat zum Gehäusesockel (4) ausgebildete, an den Gehäusesockel (4) ansetzbare Seitenteile (14, 15),
i. welche die Hauptseitenwände (6, 7) miteinander verbinden und welche an das Grundgehäuse (1) ansetzbar und dort rastend festgelegt sind und welche zu den Hauptseitenwänden (6, 7) senkrecht ausgerichtet sind und in einer Draufsicht eine U-förmige Kontur mit Längsschenkeln aufweisen,
ii. wobei die Seitenteile (14, 15) im Bereich ihrer Längsschenkel an deren Rändern in Z-Richtung Randabschnitte (17, 18) aufweisen, in denen die Wandstärke der Seitenteile an ihren voneinander abgewandten Außenflächen etwas geringer ist als in ihrem übrigen Bereich und wobei der Abstand der Längsschenkel (19, 20) der Seitenteile (14, 15) derart bemessen ist, dass ihr äußerer Abstand dem Abstand (X1) der Hauptseitenwände (6, 7) entspricht und wobei die Randabschnitte (17, 18) derart ausgelegt sind, dass sie in Anreihrichtung von innen die Hauptseitenwände (6, 7) hintergreifen, derart, dass im zusammengesetzten Zustand ein Uberlappungsbereich (21) zwischen den Randabschnitten (17, 18) und den Hauptseitenwänden (6, 7) gebildet ist,
d. wobei auch in einem unteren, zur Tragschiene gerichteten Bereich zwischen den Seitenteilen (14,15) und den Hauptseitenwänden (6, 7) der Überlappungsbereich (21) ausgebildet ist wobei der Überlappungsbereich breiter als 5mm ist,
**dadurch gekennzeichnet, dass**
e. der Überlappungsbereich zumindest abschnittsweise auch in einem Bereich ausgebildet ist. in welchem die Seitenteile (14, 15) in den Gehäusesockel (4) eingreifen.

2. Elektronikgehäuse nach Anspruch 1, **dadurch gekennzeichnet, dass** der oder die Überlappungsbereiche (21) 6 - 9 mm breit ist.

3. Elektronikgehäuse nach Anspruch 2. **dadurch gekennzeichnet, dass** der Überlappungsbereich (21) 8 mm breit ist.

4. Elektronikgehäuse nach Anspruch 2, **dadurch gekennzeichnet, dass** das Elektronikgehäuse ESD-sicher ausgestaltet ist.

5. Elektronikgehäuse nach einem der vorstehenden Ansprüche, **dadurch gekennzeichnet, dass** an der wenigstens einen oder an der Leiterplatte (LP) einer oder mehrere Steckverbinder (11) angeordnet sind.

6. Elektronikgehäuse nach einem dem vorstehenden Anspruch, **dadurch gekennzeichnet, dass** die Leiterplatten (LP) mit den Steckverbindern (11) und den Seitenteilen (14, 15) eine vormontierbare Einheit bilden, die in den Gehäusesockel (4) einsetzbar ist.

7. Elektronikgehäuse nach Anspruch 5 oder 6, **dadurch gekennzeichnet, dass** die Steckverbinder als Stiftleisten (11) oder als Buchsenleisten (12) ausgebildet sind.

8. Elektronikgehäuse nach einem der vorstehenden Ansprüche 5 bis 7, **dadurch gekennzeichnet, dass** die Leiterplatte(n) jeweils jedenfalls abschnittsweise eine sägezahnartige Seitenkontur aufweisen, wobei gestufte Abschnitte (10) gebildet werden, auf denen die Steckverbinder (11) angeordnet sind, wobei sie sich in Anreihrichtung (X) erstrecken.

## Claims

1. Multiple alignable electronic housing (1) to receive at least one printed circuit board (LP) or several printed circuit boards (LP),
a. with a catch foot with catch means (2, 3) for locking upon an assembly base designed as a mounting rail;
b. with a preferably integrally designed housing base (4) which comprises the catch foot and a bottom section (5) and two mutually parallel main side walls (6, 7) that respectively limit the electronic housing in the direction of alignment;
c. several side parts (14, 15), which are made separately from the housing base (4) and which can be placed upon the housing base (4);
i. which connect the main side walls (6, 7) to one another and which can be placed upon the base housing (1) and fixed there in a latching manner and which are aligned perpendicularly to the main side walls (6, 7) and, in a plan view, have a U-shaped contour with longitudinal legs;
ii. wherein the side parts (14, 15) have edge sections (17, 18) in the region of their longitudinal legs at their edges in the Z direction, in which the wall thickness of the side parts at their outer surfaces facing away from each other is somewhat less than in their remaining region, and wherein the spacing of the longitudinal legs (19, 20) of the side parts (14, 15) is dimensioned in such a manner that their outer spacing corresponds to the spacing (X1) of the main side walls (6, 7), and wherein the edge sections (17, 18) are designed in such a way that they engage behind the main side walls (6, 7) from the inside in the direction of alignment in such a way that, in the assembled state, an overlapping area (21) is formed between the edge sections (17, 18) and the main side walls (6, 7),
d. wherein the overlapping area (21) is also formed in a lower region facing the mounting rail between the side parts (14, 15) and the main side walls (6, 7), wherein the overlapping area is wider than 5 mm, **characterized in that**
e. the overlapping area is also arranged at least in sections in a region in which the side parts (14, 15) engage in the housing base (4).

2. An electronic housing according to claim 1, **characterized in that** the overlapping area or areas (21) is/are 6-9 mm wide.

3. An electronic housing according to claim 2, **characterized in that** the overlapping area (21) is 8 mm wide.

4. An electronic housing according to claim 2, **characterized in that** the electronic housing is made ESD-proof.

5. An electronic housing according to one of the preceding claims, **characterized in that** one or several plug connectors (11) are arranged on the at least one or on the printed circuit board (LP).

6. An electronic housing according to the preceding claim, **characterized in that** the printed circuit boards (LP) with the plug connectors (11) and the side parts (14, 15) form a premountable unit that can be inserted into the housing base (4).

7. An electronic housing according to claim 5 or 6, **characterized in that** the plug connectors are made as pin strips (11) or as socket strips (12).

8. An electronic housing according to one of the preceding claims 5 to 7, **characterized in that** the printed circuit board or printed circuit boards respectively have a sawtooth-like side contour at least in sections, wherein graduated sections (10) are formed on which the plug connectors (11) are arranged, wherein they extend in the direction of alignment (X).

## Revendications

1. Boîtier électronique (1) en plusieurs parties pouvant être assemblé en alignement pour loger au moins une carte de circuits imprimés (LP) ou plusieurs cartes de circuits imprimés (LP),
a. avec un pied d'enclenchement muni de moyens d'enclenchement (2, 3) pour s'enclencher sur une base de montage conçue comme un rail portant,
b. avec une embase de boîtier (4) conçue de préférence d'un seul tenant qui comporte le pied d'enclenchement et avec une partie de fond (5) et deux parois latérales principales (6, 7) parallèles l'une à l'autre, qui délimitent le boîtier électronique dans chaque direction d'alignement,
c. une ou plusieurs parties latérales (14, 15) formées séparément de l'embase de boîtier (4) et pouvant être posées sur l'embase de boîtier (4),
i. qui relient entre elles les parois latérales principales (6, 7) et qui peuvent être posées sur le corps de base (1) et y être fixées par enclenchement et qui sont orientées perpendiculairement aux parois latérales principales (6, 7) et présentent en vue de dessus un contour en forme de U avec des bras longitudinaux ;
ii. les parties latérales (14, 15) présentant au niveau de leurs bras longitudinaux, sur les bords de ceux-ci dans le sens de l'axe Z, des parties de bord (17, 18) dans lesquelles l'épaisseur de paroi des parties latérales sur leurs surfaces extérieures tournées à l'opposé l'une de l'autre est un peu inférieure à celle du reste de la zone et la distance entre les bras longitudinaux (19, 20) des parties latérales (14, 15) étant dimensionnée de telle façon que leur distance extérieure correspond à la distance (X1) des parois latérales principales (6, 7) et les parties de bord (17, 18) étant conçues de façon à se mettre en prise par l'intérieur derrière les parois latérales principales (6, 7) dans le sens d'alignement, de manière à former dans l'état assemblé une zone de recouvrement (21) entre les parties de bord (17, 18) et les parois latérales principales (6, 7),
d. dans lequel la zone de recouvrement (21) est formée aussi dans une partie inférieure tournée vers le rail portant, entre les parties latérales (14, 15) et les parois latérales principales (6, 7), la largeur de la zone de recouvrement étant supérieure à 5 mm,
**caractérisé en ce que**
e. la zone de recouvrement est formée au moins en partie aussi dans une zone dans laquelle les parties latérales (14, 15) se mettent en prise dans l'embase de boîtier (4).

2. Boîtier électronique selon la revendication 1, **caractérisé en ce que** la ou les zones de recouvrement (21) sont larges de 6 à 9 mm.

3. Boîtier électronique selon la revendication 2, **caractérisé en ce que** la zone de recouvrement (21) est large de 8 mm.

4. Boîtier électronique selon la revendication 2, **caractérisé en ce que** le boîtier électronique est conçu pour être insensible aux décharges d'électricité statique.

5. Boîtier électronique selon l'une des revendications précédentes, **caractérisé en ce qu'**un ou plusieurs connecteurs enfichables (11) sont disposés sur l'au moins une ou les cartes de circuits imprimés (LP).

6. Boîtier électronique selon l'une des revendications précédentes, **caractérisé en ce que** les cartes de circuits imprimés (LP) forment avec les connecteurs enfichables (11) et les parties latérales (14, 15) une unité pouvant être préassemblée, qui peut être insérée dans l'embase de boîtier (4).

7. Boîtier électronique selon la revendication 5 ou 6, **caractérisé en ce que** les connecteurs enfichables sont conçus comme des réglettes à broches (11) ou comme des réglettes à douilles (12).

8. Boîtier électronique selon l'une des revendications 5 à 7, **caractérisé en ce que** la ou les cartes de circuits imprimés présentent chacune au moins par zones un contour latéral en dents de scie, ce qui forme des parties en gradins (10) sur lesquelles sont disposés les connecteurs enfichables (11), qui s'étendent dans le sens d'alignement (X).
